# EUROPÄISCHE PATENTSCHRIFT

(11) **EP 0 862 197 B1**
(45) Veröffentlichungstag und Bekanntmachung des Hinweises auf die Patenterteilung: **09.06.1999**
(21) Anmeldenummer: 98102655.2
(22) Anmeldetag: 17.02.1998
(51) Int. Cl.: H01H 37/76, H04M 3/18

(54) **Schutzstecker**
Safety plug
Fiche de protection

(30) Priorität: 28.02.1997 DE 19710183
(43) Veröffentlichungstag der Anmeldung: 02.09.1998
(73) Patentinhaber: KRONE Aktiengesellschaft, 14167 Berlin (DE)
(72) Erfinder: Oltmanns, Johann, Dipl.-Ing., 12169 Berlin (DE); Busse, Ralf-Dieter, Dipl.-Ing., 12679 Berlin (DE); Klein, Harald, Dipl.-Ing., 13051 Berlin (DE); Richter, Gerd, 14167 Berlin (DE)

(56) Entgegenhaltungen:
- DE-A- 4 437 122
- US-A- 5 191 605
- US-A- 5 357 568

## Beschreibung

Die Erfindung betrifft einen Schutzstecker, insbesondere einen Überspannungsschutzstecker in Telekommunikationsanlagen gemäß dem Oberbegriff des Anspruches 1.

In der DE 44 37 122 C2 ist bereits ein gattungsgemäßer Schutzstecker beschrieben, der aus einem Gehäuse mit einer Leiterplatte, einem Überspannungsableiter, einem Lotformteil, das beim Überschreiten einer bestimmten Temperatur des Überspannungsableiters aufgeschmolzen wird, einem Schieber, einer Feder, einem Erdblech und einem Signalisierungselement, einem am Schieber angebrachten Federarm, besteht.

Der Grobschutz wird in bekannter Weise mit einem Überspannungsableiter realisiert. Der mit dem Überspannungsableiter verbundene Fail-Safe-Mechanismus realisiert einen Thermoschutz bei Überlastung des Überspannungsableiters, indem er die Fernmeldeadern a,b gegen Erde kurzschließt. Dieser Kurzschluß-Mechanismus wird durch einen Schieber realisiert, über den an der Rückseite des Steckers ein rotes Signalisierelement deutlich sichtbar aus dem Stecker hervortritt, wenn ein Überspannungsfall auftritt.

Die Auslösung des Fail-Safe-Kontaktes wird durch ein Lotformteil realisiert. Die Erwärmung des Überspannungsableiters bewirkt über ein angeschweißtes oder angeklemmtes Leitblech das Abschmelzen des Lotformteils. Das Lotformteil steht unter einer minimalen, genau ausbalancierten und durch den Schieber ausgeübten Federkraft (Druckkraft), die an der Grenze der Selbsthemmung des Schiebers liegt. Durch eine Schrägstellung einer Abstützfläche des Schiebers wird weitgehend eine Entkopplung des Lotformteils und der Federkraft des Schiebers erreicht. Der im Betriebsfall durch eine Kante am Gehäuse gehaltene Schieber wird aufgrund des Schmelzens des Lotformteils und des damit freiwerdenden Federweges von der Kante frei. Der Schieber bewegt sich aufgrund einer an ihm montierten Druckfeder, die sich an einer Gehäuseinnenwand abstützt, nach hinten.

Im hinteren Bereich des Steckers ist am Schieber ein rotes Kunststoffteil als Signalisierelement so angeordnet, daß es bei Bewegung des Schiebers nach hinten aus dem Stecker herausgeschwenkt wird und gut sichtbar die Auslösung anzeigt.

In einigen Anwendungsfällen ist es wünschenswert, die mechanische Signalisierung einer Auslösung durch elektronische Mittel zu ersetzen sowie einen reversiblen Überstromschutz einzusetzen, um den Austausch von Sicherungen bzw. des Steckers zu vermeiden.

Der Erfindung liegt die Aufgabe zugrunde, einen Schutzstecker für den zuverlässigen Schutz vor Überspannungen zu entwickeln, bei dem der Schaltkontakt vereinfacht ausgeführt ist und eine automatisierte Fertigung mit geringen Kosten gewährleistet wird.

Die Lösung der Aufgabe ergibt sich aus den Merkmalen des Anspruches 1. Durch die Vereinfachung des Schaltkontaktes (Fail-Safe-Mechanismus) werden eine sichere Auslösung und eine unkomplizierte, automatisierbare Montage gewährleistet.

Die separate Ausführung des Leitbleches vom Überspannungsableiter ermöglicht es, Überspannungsableiter unterschiedlicher Hersteller einzusetzen, ohne konstruktive Veränderungen vornehmen zu müssen.

Die Anwendung von temperaturabhängigen Widerständen zum Überstromschutz, deren Anschlußdrähte so geschnitten und zurechtgebogen sind, daß eine axiale Aufbringung auf der Leiterplatte ermöglicht wird, gewährleistet einen reversiblen Überstromschutz, d.h., der Stecker bleibt diesbezüglich nach einem Auslösevorgang funktionsfähig.

Der Schutzstecker ist mit SMD (surface mounted device)-Technologien bestückbar.

Weitere vorteilhafte Ausgestaltungen der Erfindung sind in den Unteransprüchen enthalten.

Die Erfindung ist nachfolgend anhand eines in den Zeichnungen dargestellten Ausführungsbeispieles eines Schutzsteckers näher erläutert. Es zeigen:
- Fig. 1: die Seitenansicht des geöffneten Schutzsteckers in Schnittdarstellung,
- Fig. 2: die Seitenansicht des Schaltkontaktes im nichtausgelösten und im ausgelösten Zustand,
- Fig. 3: die perspektivische Darstellung des Schaltkontaktes und
- Fig. 4: die perspektivische Darstellung des Leitblechs.

Der Schutzstecker ist insbesondere als Überspannungsschutzstecker zur Anwendung in Telekommunikationsanlagen in Verbindung mit Trenn- und Schaltleisten vorgesehen und schützt gegen transiente Überspannungen und induktive Ströme. Der Schutzstecker besteht aus einem Grobschutz mit Fail-Safe und einem Stromschutz in Form eines reversiblen Sicherungselementes. Darüber hinaus befinden sich am Schutzstecker Kontaktflächen, die mit Hilfe einer Meßschnur abgegriffen werden können. Dabei werden die Fernmeldelinien a, b vorteilhafterweise gleichzeitig abgegriffen. Bei einer auftretenden Überspannung, z.B. durch eine Berührung der Fernmeldelinien a, b mit örtlichen Stromversorgungsspannungen (bis 220 Veff), werden diese über einen Schaltkontakt (Fail-Safe-Mechanismus) kurzgeschlossen.

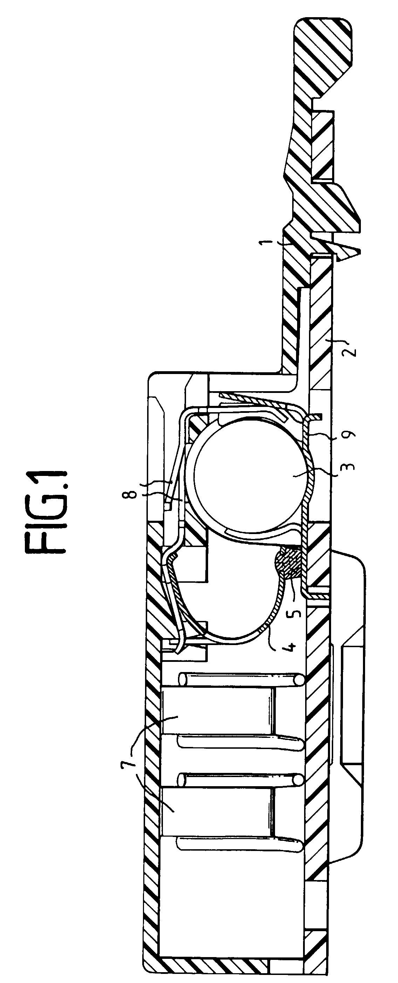

In der Fig. 1 sind in einer Seitenansicht des geöffneten Steckers die wesentlichen Bestandteile des Schutzsteckers in ihrem konstruktiven Zusammenhang gezeigt.

Entpsrechend der Darstellung in der Fig. 1 besteht der Schutzstecker aus einem äußeren Gehäuse 1, dessen Unterseite von einer Leiterplatte 2 mit einem Leitblech 9, mit einem Überspannungsableiter 3 und mit Überstrom-Sicherungselementen 7 abgeschlossen ist, aus einem Schaltkontakt 4 mit einem Lotformteil 5 und aus einem Erdkontakt 8. Der Schutzstecker wird über den Erdkontakt 8 mit der nicht dargestellten Erdschiene einer nicht dargestellten Anschlußleiste und darüber mit der Erdung des Schutzsystems verbunden.

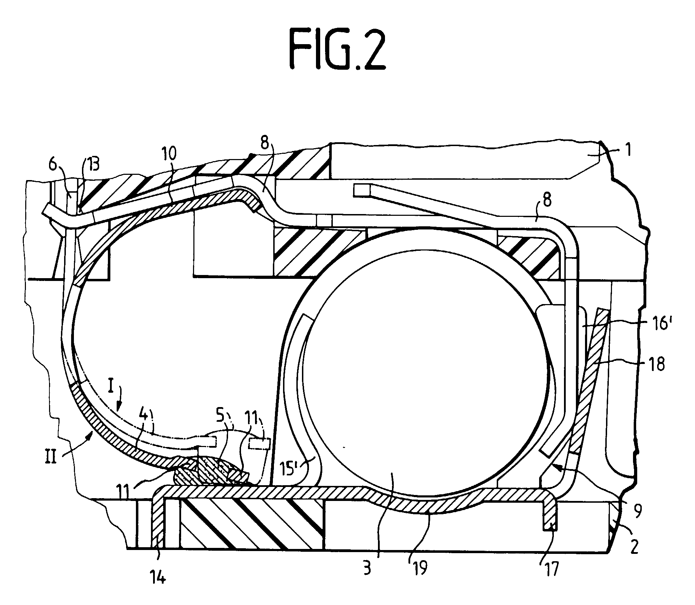

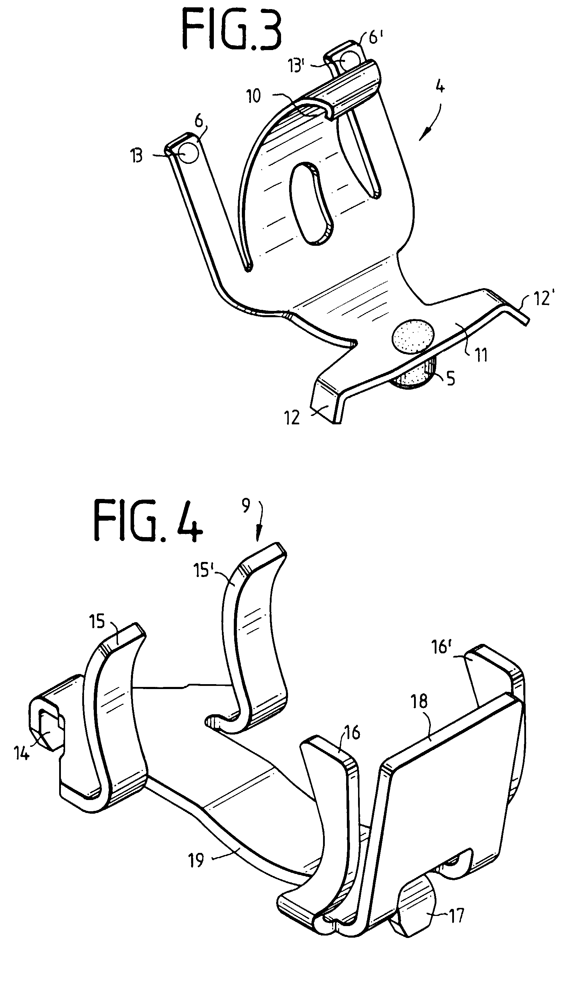

Der Schaltkontakt 4 steht mit seinem Kontaktblech 10 (Fig.3) über den Erdkontakt 8 mit der Erde und über das Lotformteil 5 mit dem Leitblech 9 des Überspannungsableiters 3 in Verbindung. Bei Erwärmung des Überspannungsableiters 3 wird über das Leitblech 9 Wärme an das Lotformteil 5 geleitet. Der Schaltkontakt 4 bewegt sich aus der nichtausgelösten Stellung I mit seinen zwei Kontaktflügeln 11,11' (Fig.3) auf zwei nicht dargestellte Kontaktflächen der Leiterplatte 2 (Fig.2). Die Kontaktflächen auf der Leiterplatte 2 sind jeweils Kontaktpunkte der Fernmeldeadern a,b (nicht dargestellt). Über die am Schaltkontakt 4 angeordneten Kontaktflügel 11,11' werden die Adern a,b an die Erde angeschlossen.

Der Stromschutz wird durch die SMD-Elemente 7 (Fig. 1) gewährleistet, die über Lötpads auf der Leiterplatte 2 (nicht dargestellt) kontaktiert sind.

Die Fig. 2 zeigt die Seitenansicht des Schaltkontaktes 4 in Verbindung mit dem Lotformteil 5 und in Verbindung mit dem Erdkontakt 8, der in funktioneller Verbindung mit dem Leitblech 9 und dem Überspannungsableiter 3 steht. Der Schaltkontakt 4 hat die Funktion eines Fail-Safe-Kontaktes und ist konstruktiv so gestaltet, daß er sich im wesentlichen als halbkreisförmig gebogenes Bauteil darstellt, welches auch im ausgelösten Zustand II noch genügend Federkraft aufweist, um die notwendigen Kontaktkräfte für die Verbindung zum Erdkontakt 8 und zu den Fernmeldelinien a, b zu gewährleisten.

Entsprechend der Darstellung in der Fig. 3 weist der Schaltkontakt 4 zwei Kontaktschenkel 6,6' auf, die seitlich vom Kontaktblech 10 herausgebogen sind, und die als Standbeine zum definierten Stellen des Schaltkontaktes 4 im Gehäuse 1 dienen. Die Kontaktschenkel 6,6' weisen je einen Noppen 13,13' auf, um ein Herausziehen aus den Gehäuseausnehmungen zu verhindern. Das Kontaktblech 10 wirkt im Gehäuse 1 als drittes Standbein und als Kontakt für den Erdkontakt 8. Am anderen Ende des Schaltkontaktes 4 sind symmetrisch zum mittig angeordneten Lotformteil 5 die zwei Kontaktflügel 11,11' mit nach unten abgewinkelten Kontaktkrallen 12,12' ausgeformt, die im ausgelösten Zustand II mit den im Signalweg liegenden Kontaktflächen der Leiterplatte 2 kontaktieren und damit die Fernmeldelinien a, b gegen Erde kurzschließen und den Überstrom ableiten. Das Lotformteil 5 in der Mitte zwischen den Kontaktflügeln 11,11' ist eine zylinderförmige Lotpille, die im fertig montierten Zustand auf dem Leitblech 9 des Überspannungsableiters 3 steht.

Bei einer Berührung der Fernmeldelinien a, b mit Stromversorgungsspannungen zündet zunächst der Überspannungsableiter 3 und leitet den Strom gegen Erde ab. Hält diese Störung an, erwärmt er sich und seine Umgebung und bewirkt über die feste Verbindung zum Leitblech 9 über Wärmestrahlung und Wärmeleitung ein Abschmelzen der Lotpille 5 und ein Auslösen des Schaltkontaktes 4.

Die Montage des Schutzsteckers ist automatisierbar. Alle Einzelteile sind so konstruiert, daß sich diese manuell oder durch eine Fertigungsstraße zusammenfügen lassen.

Der Erdkontakt 8 wird von vorne durch horizontales Einfügen im Gehäuse 1 kontaktiert. In diesem Bereich sind das Gehäuse 1 und der Erdkontakt 8 so gestaltet, daß der Erdkontakt 8 mit der bekannten Erdschiene (nicht dargestellt) kontaktiert.

Das mit dem Erdkontakt 8 bestückte Gehäuse 1 wird so gewendet, daß die offene Gehäuseunterseite nach oben zeigt. Der Schaltkontakt 4 wird von oben in im Gehäuse 1 befindliche Öffnungen so eingestellt, daß das am Schaltkontakt 4 beispielsweise angenietete Lotformteil 5 nach oben zeigt.

Zum Abschluß der Montage wird die mit Leitblech 9, Überspannungsableiter 3 und mit zwei Überstromschutzelementen 7 bestückte Leiterplatte 2 mit der Bestückungsseite nach unten auf das Gehäuse 1 gerastet, wobei die Leiterplatte 2 mit den Steckkontaktflächen in Richtung der Gehäusespitze gehalten wird. Die Rastung erfolgt im wesentlichen an den langen Seiten im hinteren Bereich der Leiterplatte 2 (nicht dargestellt). Ein weiterer kleiner Rasthaken befindet sich im vorderen Bereich der Gehäusespitze.

Alle elektronischen Bauelemente werden durch einen Reflowlötprozeß auf die Leiterplatte 2 gelötet.

Entsprechend der Darstellung in der Fig. 4 wird das Leitblech 9 als erstes auf die mit Lotpaste bedruckte Leiterplatte 2 gesetzt. Dabei rasten zwei Laschen 14, 17 des Leitblechs 9 in entsprechende Aussparungen der Leiterplatte 2 ein. Damit wird eine genaue Positionierung des Überspannungsableiters 3 erreicht. Danach wird der Überspannungsableiter 3 in das mit Lotpaste beschichtete Leitblech 9 zwischen jeweils zwei Haltelaschen 15,15' und 16,16' so eingeklemmt, daß diese auf elektrisch nichtleitenden Abschnitten des Überspannungsableiters 3 aufliegen. Die Überstromschutzelemente 7 werden auf die dafür vorgesehenen Pad's der Leiterplatte 2 gesetzt. Die handelsüblichen axialen Bauelemente werden vorher dahingehend vorbereitet, daß deren Anschlußdrähte so abgeschnitten und gebogen werden, daß sie als SMD-Bauelemente verwendet werden können. Durch den Reflowlötprozeß werden alle Bauelemente mit der Leiterplatte 2 verlötet und gleichzeitig wird eine Lötverbindung zwischen dem Basisteil 19 des Leitblechs 9 und dem Überspannungsableiter 3 hergestellt.

### BEZUGSZEICHENLISTE

- 01: Gehäuse
- 02: Leiterplatte
- 03: Überspannungsableiter
- 04: Schaltkontakt
- 05: Lotformteil
- 6,6': Kontaktschenkel
- 07: Überstromschutzelement
- 08: Erdkontakt
- 09: Leitblech
- 10: Kontaktblech
- 11,11': Kontaktflügel
- 12,12': Kontaktkralle
- 13,13': Noppen
- 14: Lasche
- 15,15': Haltelasche
- 16,16': Haltelasche
- 17: Lasche
- 18 19: Basisteil

- I,II: Zustand

## Patentansprüche

1. Schutzstecker, insbesondere Überspannungsschutzstecker in Telekommunikationsanlagen, bestehend aus einem Gehäuse mit einer Leiterplatte, einem Überspannungsableiter mit Leitblech, einem Lotformteil, das beim Überschreiten einer bestimmten Temperatur des Überspannungsableiters aufgeschmolzen wird, einem Erdblech, einem mit dem Lotformteil und dem Erdblech verbundenen Federarm, einem Überstromschutzelement,
**dadurch gekennzeichnet,** daß
der Federarm durch einen gebogenen Schaltkontakt (4) gebildet ist, an dem das Lotformteil (5) angeordnet ist, welcher vor dem Auslösen mit dem Erdblech (8) und mit dem Leitblech (9) und nach dem Auslösen zusätzlich mit den Fernmeldelinien (a,b) in Kontakt gebracht ist.

2. Schutzstecker nach Anspruch 1, dadurch gekennzeichnet, daß der Schaltkontakt (4) im wesentlichen halbkreisförmig ausgebildet ist.

3. Schutzstecker nach Anspruch 1, dadurch gekennzeichnet, daß das Leitblech (9) ein separates Bauteil bildet und mit dem Überspannungsableiter (3) verlötet wird.

4. Schutzstecker nach den Ansprüchen 1 und 2, dadurch gekennzeichnet, daß der Schaltkontakt (4) an seinem einen Ende zwei Kontaktschenkel (6,6') aufweist, die sich als Standbeine im Gehäuse (1) definiert abstützen, und daß an seinem anderen Ende zwei symmetrisch angeordnete Kontaktflügel (11,11') mit je einer abgewinkelten Kralle (12,12') ausgebildet sind, die im ausgelösten Kontaktzustand (II), in welchem das Lotformteil (5), welches zwischen den Kontaktflügeln (11,11') auf dem Leitblech (9) mit dem Überspannungsableiter (3) angeordnet ist, geschmolzen ist, auf die Leiterbahnen der Fernmeldelinien (a,b) direkt aufsetzen und diese gegen Erde kurzschließen.

5. Schutzstecker nach Anspruch 1, dadurch gekennzeichnet, daß der Überstromschutz durch mindestens einen temperaturabhängigen Widerstand (7) auf Polymerbasis reversibel gebildet ist.

6. Schutzstecker nach Anspruch 5, dadurch gekennzeichnet, daß die Anschlußdrähte des temperaturabhängigen Widerstandes (7) so abgewinkelt und gebogen sind, daß die SMD-Technologie zur Bestückung der Leiterplatte (2) anwendbar ist.

## Claims

1. Protective plug, in particular an overvoltage protective plug in telecommunications systems, comprising a housing having a printed circuit board, an overvoltage suppressor with a conductive plate, a solder moulding which melts if the overvoltage suppressor exceeds a specific temperature, an earth plate, a spring arm which is connected to the solder moulding and to the earth plate, and an overcurrent protective element, **characterized in that**
the spring arm is formed by a bent switching contact (4) on which the solder moulding (5) is arranged, which solder moulding is moved into contact, before tripping, with the earth plate (8) and with the conductive plate (9) and, after tripping, is additionally moved into contact with the telecommunications lines (a, b).

2. Protective plug according to Claim 1, characterized in that the switching contact (4) is essentially semicircular.

3. Protective plug according to Claim 1, characterized in that the conductive plate (9) forms a separate component and is soldered to the overvoltage suppressor (3).

4. Protective plug according to Claims 1 and 2, characterized in that the switching contact (4) has, at one of its ends, two contact limbs (6, 6') which are supported in a defined manner as stand legs in the housing (1), and in that, at its other end, two symmetrically arranged contact vanes (11, 11') are formed, each having an angled claw (12, 12') which, in the tripped contact state (II) in which the solder moulding (5), which is arranged between the contact vanes (11, 11') on the conductive plate (9) with the overvoltage suppressor (3), is melted, are placed directly on the conductor tracks of the telecommunications lines (a, b) and short them to earth.

5. Protective plug according to Claim 1, characterized in that the overcurrent protection is formed reversibly by at least one temperature-dependent resistor (7) on a polymer base.

6. Protective plug according to Claim 5, characterized in that the connecting wires of the temperature-dependent resistor (7) are angled and bent such that SMD technology can be used for populating the printed circuit board (2).

## Revendications

1. Fiche de protection, en particulier fiche de protection contre les surtensions dans des installations de télécommunication, composée d'un boîtier avec une carte imprimée, d'un dérivateur de surtension avec tôle-guide, d'une pastille de brasure qui fond lorsqu'une température déterminée du dérivateur de surtension est dépassée, d'une tôle de terre, d'un bras à ressort relié à la pastille de brasure et à la tôle de terre, d'un élément de protection contre la surintensité, caractérisée en ce que le bras à ressort est formé par un contact de commutation courbe (4) sur lequel est disposée la pastille de brasure (5), et qui est mis en contact avant le déclenchement avec la tôle de terre (8) et avec la tôle-guide (9) et, après le déclenchement, en outre avec les lignes de télécommunication (a,b).

2. Fiche de protection suivant la revendication 1, caractérisée en ce que le contact de commutation (4) est essentiellement en forme de demi-cercle.

3. Fiche de protection suivant la revendication 1, caractérisée en ce que la tôle-guide (9) forme une partie constituante séparée et est brasée avec le dérivateur de surtension (3).

4. Fiche de protection suivant les revendications 1 et 2, caractérisée en ce que le contact de commutation (4) présente à l'une de ses extrémités deux branches de contact (6,6') qui prennent appui de façon bien définie comme des pieds fixes dans le boîtier (1), et en ce que, à son autre extrémité, deux ailes de contact agencées symétriquement (11,11') sont formées chacune avec une griffe coudée (12,12'), lesquelles, dans l'état déclenché des contacts (II) dans lequel la pastille de brasure (5), disposée entre les ailes de contact (11,11') sur la tôle-guide (9) avec dérivateur de surtension (3), est fondue, se posent directement sur les pistes conductrices des lignes de télécommunication (a,b) et court-circuitent celles-ci à la terre.

5. Fiche de protection suivant la revendication 1, caractérisée en ce que la protection contre la surintensité est formée de manière réversible par au moins une résistance variant avec la température (7) sur une base polymère.

6. Fiche de protection suivant la revendication 5, caractérisée en ce que les fils de connexion de la résistance variant avec la température (7) sont coudés et pliés de telle sorte que la technologie des composants montés en surface est applicable pour l'implantation sur la carte imprimée (2).
